# EUROPÄISCHE PATENTSCHRIFT

(11) **EP 1 774 378 B1**
(45) Veröffentlichungstag und Bekanntmachung des Hinweises auf die Patenterteilung: **23.07.2014**
(21) Anmeldenummer: 05776178.5
(22) Anmeldetag: 05.08.2005
(51) Int. Cl.: G02B 6/122, G02B 6/138, C30B 29/60

(54) **VERFAHREN ZUR HERSTELLUNG EINES PHOTONISCHEN KRISTALLS, DER AUS EINEM MATERIAL MIT HOHEM BRECHUNGSINDEX BESTEHT**
METHOD FOR PRODUCING A PHOTONIC CRYSTAL COMPRISED OF A MATERIAL WITH A HIGH REFRACTIVE INDEX
PROCEDE POUR PRODUIRE UN CRISTAL PHOTONIQUE CONSTITUE D'UNE MATIERE QUI PRESENTE UN INDICE DE REFRACTION ELEVE

(30) Priorität: 05.08.2004 DE 102004037950
(43) Veröffentlichungstag der Anmeldung: 18.04.2007
(73) Patentinhaber: Karlsruher Institut für Technologie, 76131 Karlsruhe (DE); UNIVERSITY OF TORONTO, Toronto, Ontario M5S 1A1 (CA)
(72) Erfinder: VON FREYMANN, Georg Ludwig Eberhard, Toronto, Ontario M2J2B4 (CA); OZIN, Geoffrey A., Toronto, Ontario M4V1Y9 (CA); DEUBEL, Markus, 76889 Schweighofen (DE); WEGENER, Martin, 76127 Karlsruhe (DE); TETREAULT, Nicolas, Toronto, Ontario M4KI2B (CA)
(74) Vertreter: Fitzner, Uwe
(86) Internationale Anmeldenummer: PCT/EP2005/054232
(87) Internationale Veröffentlichungsnummer: WO 2006/015990

(56) Entgegenhaltungen:
- WO-A2-2004/038467
- US-A1- 2002 062 782
- US-A1- 2002 143 073
- US-A1- 2004 172 973
- US-B1- 6 517 763
- CAMPBELL M ET AL: "FABRICATION OF PHOTONIC CRYSTALS FOR THE VISIBLE SPECTRUM BY HOLOGRAPHIC LITHOGRAPHY" NATURE, Bd. 404, 2. März 2000 (2000-03-02), Seiten 53-56, XP000953885 ISSN: 0028-0836 in der Anmeldung erwähnt

## Beschreibung

Diese Anmeldung nimmt die Priorität der DE 10 2004 037 950.5 in Anspruch.

Die Erfindung betrifft ein Verfahren zur Herstellung eines dreidimensionalen Photonischen Kristalls, der aus einem Material mit einem hohen Brechungsindex besteht.

Photonische Kristalle, die auf E. Yablonovitch, Phys. Rev. Lett., Band 58, Seite 2059-2062, 1987, und S. John, ebd., Seite 2486-2489, 1987, zurückgehen sind periodisch strukturierte dielektrische Materialien, die das optische Analogon von Halbleiter-kristallen darstellen und so die Herstellung integrierter photonischer Schaltkreise ermöglichen.

Ausgedehnte Photonische Bandlücken, die nach K.-M. Ho, C.T. Chan, und C.M. Soukoulis, Phys. Rev. Lett., Band 65, Seite 3152-3155, 1990, theoretisch bis zu 25 % der Zentralfrequenz von Silizium bei 2,6 µm aufweisen können, lassen sich mit Photonischen Kristallen herstellen, die eine Diamantstruktur anstelle einer flächenzentrierten kubischen Struktur besitzen.
Insbesondere Schichtstrukturen sind gemäß K.-M. Ho, C.T. Chan, C.M. Soukoulis, R. Biswas, und M. Sigalas, Solid State Comm., Band 89, Seite 413-416, 1994, und E. Özbay et al, Phys. Rev. B, Band 50, Seite 1945-1948, 1994 über Mikrofabrikationsverfahren zugänglich. In neuerer Zeit haben S.Y. Lin et al., Nature, Band 394, Seite 251-253, 1998, S. Noda et al., Science, Band 289, Seite 604-606, 2000, und K. Aoki et al., Nature Materials, Band 2, Seite 117-121, 2003, Photonische Kristalle für infrarote Frequenzen hergestellt, indem sie planare Halbleiter-Mikrostruktrierungsverfahren für einzelne Schichten mit ausgefeilten Ausrichtungs- und Stapelungsverfahren kombiniert haben, um aus den Schichten einen dreidimensionalen Photonischen Kristall zu gestalten.

Hiermit wird eine Aufnahme von funktionalen Elementen durch gezielte Veränderungen in einzelnen Schichten möglich. Jedoch war eine Stapelung bisher nur für wenige Schichten erfolgreich, was zu einer starken Kopplung zwischen den Führungsmoden im Photonischen Kristall und den Verlustmoden im umgebenden Material führt, wodurch die Leistungsfähigkeit der funktionalen Elemente begrenzt ist.

Daher gingen M. Campbell et al., Nature, Band 404, Seite 53-56, 2000, und Y.V. Miklyaev et al., Appl. Phys. Lett., Band 82, Seite 1284-1286, 2003, dazu über, ausgedehnte dreidimensionale Photonische Kristalle hoher Qualität in Photoresistschichten mittels *holographischer Lithographie* herzustellen. Hier ist die Dicke der Photonischen Kristalle grundsätzlich nur durch die Dicke der Photoresistschicht und deren Absorption beschränkt. Die holographische Lithographie ermöglicht die Bereitstellung defektfreier Schichten mit einer Dicke von einigen 10 Einheitszellen bei einer Ausdehnung von einigen mm², wobei dieses Verfahren eine große Flexibilität im Hinblick auf den Inhalt der Einheitszelle besitzt. Allerdings erlaubt dieses Vielstrahlinterferenzverfahren nur die Herstellung strikt periodischer Strukturen.

Daher wird ein zweites komplementäres Verfahren benötigt, um funktionale Elemente wie z. B. Wellenleiter oder Mikrohohlstrukturen in das Innere eines Photonischen Kristalls, der mit holographischer Lithographie hergestellt wurde, zu schreiben. Hierfür besonders geeignet ist das aus S. Kawata, H.-B. Sun, T. Tanaka und K. Takada, Nature, Band 412, Seite 697-698, 2001, bekannte so genannte *direkte Laserschreiben* (*direct laser writing,* DLW) durch Multiphotonen-Polmerisation im photosensitiven Material.

Hierbei wird ein Photoresist mittels eines Lasers belichtet, dessen Frequenz unterhalb der Einphotonen-Polymerisationsschwelle des Photoresists liegt. Wird dieser Laser auf das Innere des Photoresists fokussiert, kann die Lichtintensität innerhalb eines kleinen Volumens im Brennpunkt die Schwelle für Multiphotonen-Polmerisation überschreiten. Größe und Form dieser so genannten *Voxel* hängen von den Isointensitäts-Oberflächen, d. h. Isophoten, dem eingesetzten mikroskopischen Objektiv und der Belichtungsschwelle für Multiphotonen-Polmerisation im photosensitiven Material ab. Mit diesem Verfahren konnten S. Kawata et al. bisher Voxel mit einer Größe bis hinunter zu 120 nm bei einer Beleuchtung bei 780 nm herstellen.

In Verbindung mit Holographischer Lithographie bietet das direkte Laserschreiben einen schnellen und genauen Weg um funktionale Elemente in Photonischen Kristallen bereitzustellen. Allerdings ist damit das Einbringen von Materialien mit hohem Brechungsindex in derartige Strukturen nicht möglich, da hohe Temperaturen für die Beschichtung und hohe chemische Reaktivität der Vorläufersubstanzen für bekannte Beschichtungsverfahren wie z. B. *Chemical Vapour Deposition* (CVD) die bestehenden Strukturen zerstören.

Aus US 200210143073 A1 und US 6,517,763 B1 ist es bekannt, Mikrostrukturen ausgehend von sphärischen opalartigen Strukturen herzustellen.

Ausgehend hiervon ist es die Aufgabe der vorliegenden Erfindung, ein Verfahren zur Herstellung eines Photonischen Kristalls, der aus einem Material mit hohem Brechungsindex besteht, vorzuschlagen, das die genannten Nachteile und Einschränkungen nicht aufweist.

Diese Aufgabe wird durch die Merkmale des Anspruchs 1 gelöst. Die Unteransprüche beschreiben jeweils vorteilhafte Ausgestaltungen der Erfindung.

Das erfindungsgemäße Verfahren stellt ein doppeltes Inversionsverfahren dar, d. h. zunächst wird der ursprüngliche polymere Photonische Kristall in eine räumlich inverse Struktur überführt, die ihrerseits durch eine zweite Inversion einen Photonischen Kristall bildet, der aus dem gewünschten Material mit hohem Brechungsindex besteht. Die Ausgangsmaterialien werden jeweils mit geeigneten Verfahren entfernt.

Der Ausgangspunkt des erfindungsgemäßen Verfahrens ist ein gemäß Verfahrensschritt a) bereitgestellter dreidimensionaler Photonischer Kristall, der aus einem Polymer besteht. Hierzu wird gemäß dem bekannten Stand der Technik vorzugsweise ein Polymer oder ein polymerisierbares Monomer mittels Spincoating auf ein erstes Substrat aus Glas, Silizium oder einem Polymer aufgebracht.

In einer besonderen Ausgestaltung deckt dieses Polymer bzw. polymerisierbare Monomer das gesamte erste Substrat ab und wird anschließend ggf. vollständig polymerisiert. Erst dann wird hierauf eine zweite Lage des Polymers oder polymerisierbaren Monomers aufgebracht.

Anschließend wird aus dem Polymer mittels direktem Laserschreiben ein polymerer Photohischer Kristall mit der gewünschten Kristallstruktur hergestellt. Ein derartiger Photonischer Kristall besitzt eine Oberfläche, durch die ein Gitter mit leeren Zwischersgitterplätzen definiert ist.

Die erste Inversion, d. h. die Überführung des ursprünglichen polymeren Photonischen Kristalls in eine räumlich inverse Struktur erfolgt, indem gemäß Verfahrensschritt b) ein geeigneter Füllstoff in die leeren Zwischengitterplätze derart eingefüllt wird, dass sich auf den Zwischengitterplätzen aus dem Füllstoff ein Netzwerk bildet.

In einer bevorzugten Ausgestaltung wird eine Vorläufersubstanz des Füllstoffs in die zunächst leeren Zwischengitterplätze eingebracht, wo diese sich auf die Oberfläche des polymeren Photonischen Kristalls ablagert. Die Menge an Vorläufersubstanz wird so gewählt, dass sich damit ein vorgegebener Volumenanteil des leeren Zwischengitters füllt, der ausreicht, um eine Schicht aus dem Füllstoff auf der Oberfläche des polymeren Photonischen Kristalls zu bilden, die ein miteinander verbundenes Netzwerk aus Füllstoff in den vorher leeren Zwischengitterplätzen des polymeren Photonischen Kristalls darstellt.

In einer besonders bevorzugten Ausgestaltung wird Siliziumtetrachlorid SiCl₄ als Vorläufersubstanz (Precursor) verwendet und anschließend auf herkömmliche Weise zum gewünschten Füllstoff Silikat SiO₂ umgesetzt.

Da nach Verfahrensschritt b) die gesamte vorhandene Polymerstruktur mit dem Füllmaterial bedeckt ist, ist eine direkte Entfernung des Polymers gemäß Verfahrensschritt c) durch thermische Zersetzung oder Plasmaätzen in der Regel nicht möglich. Thermische Zersetzung führt zu einer Erzeugung von gasförmigen Produkten innerhalb der geschlossenen Struktur und damit zu deren explosionsartiger Zerstörung; Plasmaätzen funktioniert nicht, da die reaktiven Gase das zu zersetzende Polymer durch das Füllmaterial hindurch nicht erreichen können.

In einer Ausgestaltung b1) wird diese Schwierigkeit dadurch umgangen, dass vor der Entfernung des Polymers ein zweites Substrat, das bevorzugt aus Glas oder einem anderen Material, das bei hohen Temperaturen beständig ist, sich aber in starken Säuren auslösen lässt, besteht, vorzugsweise mittels eines Sol-Gel-Verfahrens oder eines Klebstoffs (Hochleistungsklebstoffs) auf die Struktur aufgebracht wird.
Bei der hieran anschließenden thermischen Zersetzung trennen die gasförmigen Produkte das erste Substrat von der Struktur ab, die in dieser Ausgestaltung auf einer dünnen Polymerschicht ruht. Nach dieser Abtrennung sind genügend Abzugskanäle für die gasförmigen Zersetzungsprodukte des Polymers aus dem Inneren der Struktur geöffnet, so dass diese, ohne die Struktur zu zerstören, entweichen können.

In einer alternativen Ausgestaltung b2) wird diese Schwierigkeit dadurch umgangen, dass die oberste Schicht aus dem Füllstoff (Silikat) mittels reaktivem lonenätzen entfernt wird.
Auch hierdurch werden genügend Abzugskanäle für die gasförmigen Zersetzungsprodukte des Polymers aus dem Inneren der Struktur geöffnet, so dass diese, ohne die Struktur zu zerstören, entweichen können.

Wurde nach Verfahrensschritt c) das Polymer, aus dem der ursprüngliche Photonische Kristall bestand, vorzugsweise mittels Plasmaätzen oder thermischer Zersetzung entfernt, entstehen in dem aus Füllstoff gebildeten Netzwerk Hohlräume.

Aus der so gebildeten Struktur wird nun durch eine zweite Inversion der gewünschte Photonische Kristall hergestellt. Hierzu wird gemäß Verfahrensschritt d) das gewählte Material mit hohem Brechungsindex, d.h. hoher dielektrischer Konstante, in die zuvor gebildeten Hohlräume eingefüllt, so dass sich darin eine Struktur aus dem Material mit hohem Brechungsindex bildet. Vorzugsweise wird das Material mit hohem Brechungsindex schichtweise bis zur gewünschten Dicke auf die inneren Oberflächen der Hohlräume im Füllstoff aufgebracht.

Als Material mit hohem Brechungsindex werden bevorzugt die Halbleiter Silizium, auch mit verschiedenen n- oder p-Dotanten versehen, Germanium oder eine SiₓGe₁₋ₓ-Legierung eingesetzt. Silizium selbst kann amorph, nanokristallin, polykristallin oder monokristallin sein, wobei hydriertes nanokristallines Silizium (no-Si:H) ein besonders bevorzugtes Material darstellt. Darüber hinaus sind II-V-, II-VI-, I-VII-, IV-VI-Halbleiter einschließlich ihrer n- oder p-dotierten Varianten oder Metalle mit hohem Brechungsindex wie z. B. Silber (Ag), Gold (Au), Wolfram (W), Iridium (Ir) oder Tantal (Ta) ebenso geeignet.

Bevor schließlich gemäß Verfahrensschritt e) der Photonische Kristall, der aus dem Material mit hohem Brechungsindex besteht, entnommen wird, nachdem der Füllstoff entfernt wurde, wird die Struktur vorzugsweise mittels eines optisch transparenten Kleber (Optikklebers) auf ein drittes Substrat, das inert gegen starke Säuren wie z. B. Fluorwasserstoff (HF) oder Salzsäure (HCl) ist und bevorzugt aus einem Polymer optischer Qualität besteht, befestigt. Ohne diesen Schritt läuft man Gefahr, einen Photonischen Kristall mit geringer räumlicher Ausdehnung nach dem Entfernen des Füllmaterials und des Substrats in der Säure zu verlieren.

Das Entfernen des Füllstoffs, das bevorzugt mittels einer starken Säure wie z. B. Fluorwasserstoff (HF) oder Salzsäure (HCl) erfolgt, bewirkt ggf. die Entfernung des ursprünglichen Substrats und die Ausbildung des gewünschten dreidimensionalen Photonischen Kristalls aus Material mit hohem Brechungsindex, dessen Struktur ähnlich oder identisch ist mit dem in Verfahrensschritt a) bereitgestellten, polymeren dreidimensionalen Photonischen Kristall. Das Kristallgitter des so erhaltenen Photonischen Kristalls kann beispielsweise eine kubisch flächenzentrierte (*fcc*), eine einfach-kubische (sc), eine *slanted pores-,* eine Diamant- oder eine quadratische Spiral-Struktur aufweisen.

Das erfindungsgemäße Verfahren ermöglicht die Herstellung von dreidimensionalen Photonischen Kristallen mit hohem dielektrischem Kontrast. Diese können sämtliche Strukturen und Topologien aufweisen, die sich mittels direktem Laserschreiben herstellen lassen. Damit lassen sich gleichzeitig funktionele photonische Vorrichtungen auf der Grundlage von dreidimensionalen Photonischen Kristallen ohne weitere Verfahrensschritte herstellen. Mit dem erfindungsgemäßen Verfahren hergestellte Photonische Kristalle besitzen vollständige Bandlücken im Bereich der Telekommunikationswellenlängen.

Die Erfindung wird im Folgenden anhand von Ausführungsbeispielen und den Figuren näher erläutert. Es zeigen:
- **Fig. 1**: Schematische Darstellung der Verfahrensschritte für zwei Ausgestaltungen des Verfahrens.
- **Fig. 2**: Rasterelektronenmikroskopische Aufnahme einer doppelt invertierten Silizium-Struktur.
- **Fig. 3**: Berechnete photonische Bandstruktur einer doppelt invertierten Silizium-Struktur.

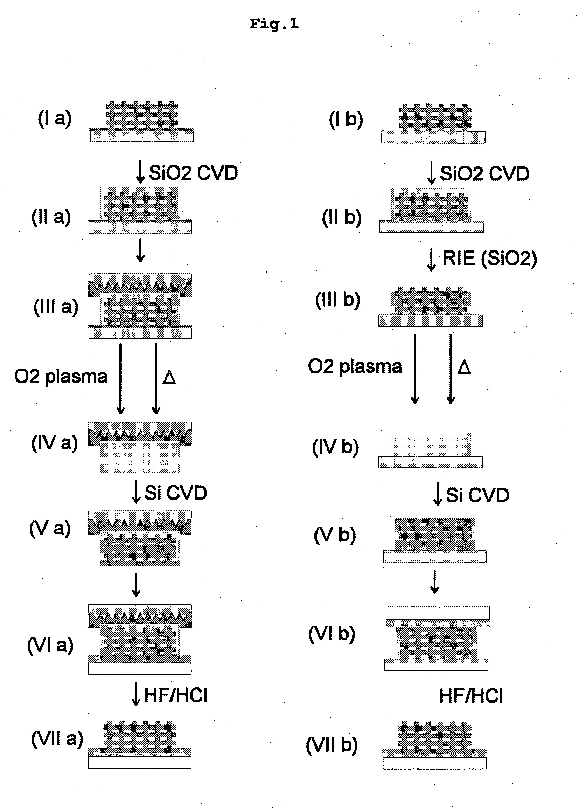

**Fig. 1** zeigt schematisch die Verfahrensschritte I-VII für zwei mit a bzw. b gekennzeichnete Ausgestaltungen des Verfahrens:
- Ia, Ib: Ausgangspunkt: Substrat (Glas) mit aufgebrachtem polymeren Photonischem Kristall, hergestellt mit Multiphononenpolymerisation (Verfahrensschritt a).
- IIa, IIb: Auffüllen der Zwischengitterplätze des polymeren Photonischen Kristalls mittels CVD von SiO₂ (Verfahrensschritt b).
- IIIa: Aufbringen eines weiteren Substrats auf die Oberfläche des Kristalls aus Polymer und SiO₂.
- IIIb: Entfernen des übefflüssigen SiO₂ mittels reaktivem Ionenätzen (RIE).
- IVa: Entfernen des ursprünglichen Substrats und des polymeren Photonischen Kristalls mittels Erwärmen (Δ) oder O₂-Plasmaätzen (Verfahrensschritt c).
- IVb: Entfernen des polymeren Photonischen Kristalls mittels Erwärmen (Δ) oder O₂-Plasmaätzen (Verfahrensschritt c).
- Va, Vb: Schichtweises Einbringen von Silizium oder eines anderen Materials mit hohem Brechungsindex in die Zwischengitterplätze der mit SiO₂ invertierten photonischen Struktur (Verfahrensschritt d).
- VIa, VIb: Aufbringen eines weiteren Substrats auf die Oberfläche des Kristalls aus Silizium und SiO₂.
- VIIa, VIIb: Entfernen des SiO₂ durch nasschemisches Ätzen in einer starken Säure (z.B. HF oder HCl) führt zu einem Photonischen Kristall aus Silizium bzw. aus einem anderen Material mit hohem Brechungsindex, dessen Hohlräume (Poren) sich mit der umgebenden Atmosphäre (Luft) füllen (Verfahrensschritt e).

Abhängig von der Anzahl der in den Schritten (II) und (V) eingebrachten Schichten lassen sich Photonische Kristalle mit verschiedenen Topologien herstellen.

Zur Durchführung des erfindungsgemäßen Verfahrens wurde gemäß Verfahrensschritt a) als Ausgangspunkt jeweils ein polymerer Photonischer Kristall bereitgestellt, der mittels direktem Laserschreiben in einen Photoresist aus EPON SU-8 eingebracht wurde und der auf ein Glassubstrat aufgebracht war, das optional mit photopolymerisiertem EPON SU-8 bedeckt war.

Anschließend wurde in den polymereren Photonischen Kristall mittels *Chemical Vapour Deposition* (CVD) beispielsweise über die Vorläufersubstanz (Precursor) SiCl₄ solange schichtweise SiO₂ eingebracht, bis eine vollständige Füllung der Polymerstruktur erreicht wurde (Verfahrensschritt b).

Im Anschluss hieran wurden alternativ zwei Ausgestaltungen, die den Verfahrensschritt c) einschließen, durchgeführt:
(a) Die Probe wurde gedreht und auf ein weiteres Substrat aufgebracht, das zum Transfer dient. In diesem Ausführungsbeispiel wurde hierfür ein Glassubstrat mit einer rauen Oberfläche gewählt. Als Klebstoff wurde beispielsweise eine Sol-Gel-Mischung aus SiO₂ (Silikat), die mit TMOS und einer kommerziell erhältlichen Suspension von Silikat-Kolloid-Teilchen in Wasser hergestellt wurde, verwendet. Ebenso wurden kommerziell erhältliche hochtemperaturbeständige Klebstoffe erfolgreich eingesetzt. Das ursprüngliche Glassubstrat und der polymere Photonische Kristall, wurden durch O₂-Plasmaätzen über 20 Stunden oder durch thermische Zersetzung des Polymers bei 450°C über 6 Stunden entfernt. Eine Kombination beider Verfahren erwies sich ebenfalls als erfolgreich.
   In dieser Ausgestaltung sollte das erste Substrat bevorzugt nach unten zeigen, um, sobald das Polymer zersetzt ist, von der Schwerkraft aufgrund fehlender Haftung abgetrennt zu werden. Sonst besteht Gefahr, dass das erste Substrat und die silikat-invertierte Struktur bei den auftretenden hohen Temperaturen zusammensintern, wodurch ein späteres Einbringen von hochbrechendem Material nicht mehr möglich ist.
(b) Die über die Oberfläche des Photonischen Kristalls hinaus gewachsene SiO₂-Struktur wurde mittels kontrolliertem reaktiven lonenätzen entfernt. Der ursprüngliche polymere Photonische Kristall wurde durch O₂-Plasmaätzen über 20 Stunden oder durch thermische Zersetzung des Polymers bei 450°C über 6 Stunden entfernt. Eine Kombination beider Verfahren erwies sich ebenfalls als erfolgreich.

Hierdurch wurde ein Spiegelbild des ursprünglichen polymeren Photonischen Kristalls erzeugt, das die hohen Temperaturen, die für die Pyrolyse der Disilan(Si₂H₆)-Vorgängersubstanz während des schichtweisen Aufbringens von hydriertem amorphen Silizium (a-Si:H) während Verfahrensschritt d) durch *Chemical Vapour Deposition* (CVD) erforderlich ist, aushält.

Der Druck wurde konstant bei 320 Pa (2,4 Torr) gehalten, während die Beschichtungsrate und die optischen Eigenschaften des Films durch die Temperatur des Substrats, die zwischen 340°C und 430°C variierten kann, festgelegt wurden.

Um hydriertes nanokristallines Silizium (nc-Si:H) zu erhalten,
wurde die Probe dann für 20 Stunden bei 600°C in einer Stickstoffatmosphäre mit 5% Wasserstoff thermisch behandelt.

Anschließend wurde die Probe gedreht und auf ein Polymethylmethacrylat(PMMA)-Substrat hoher optischer Güte oder ein anderes Substrat, das nicht in starken Säuren reagiert und die optischen Anforderungen erfüllt, gelegt, auf das ein dünner haftender Film eines photopolymerisierbaren Polymers hoher optischer Güte aufgebracht ist. Um gute Haftung zu erzielen, wurde die Probe danach für 5-10 Minuten unter eine Ultraviolettlampe gelegt.

Schließlich wurden gemäß Verfahrensschritt e) das Silikat-Substrat und der Photonische Kristall vollständig in einer Lösung aus 10 Gew.-% wässrigem Fluorwasserstoff (HF) und 12 Gew.-% wässriger Salzsäure (HCl) geätzt.

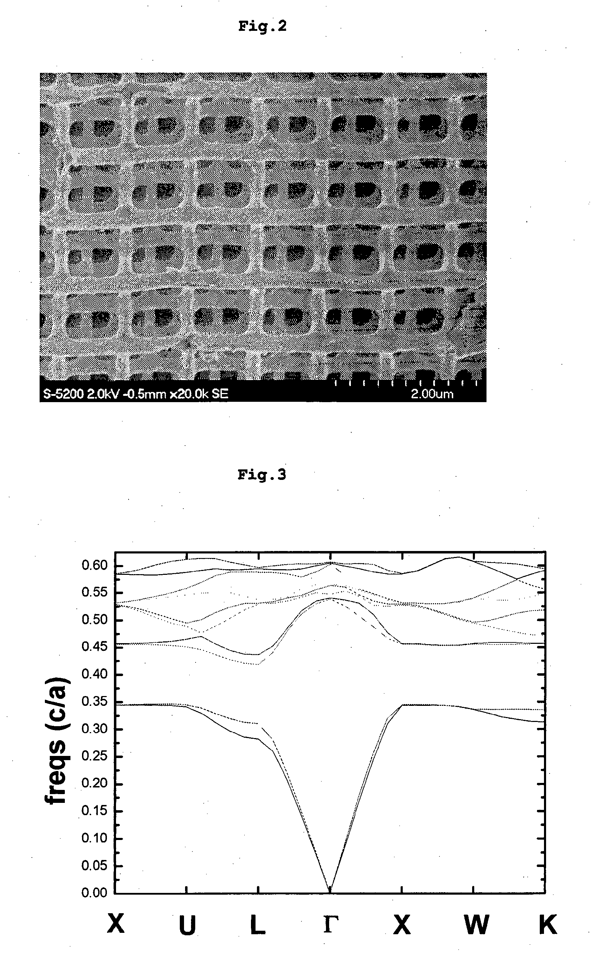

**Fig. 2** zeigt eine rasterelektronenmikroskopische (REM) Aufnahme einer erfindungsgemäß hergestellten invertierten Silizium *woodpile* Struktur in hoher Vergrößerung. Es wird deutlich, dass das Replikat vollständig invertiert ist, homogen über das gesamte Volumen der ursprünglichen Polymerstruktur verteilt ist und über eine glatte Oberfläche verfügt.

Zur Analyse der Eigenschaften der erfindungsgemäß hergestellten Photonischen Kristalle wurden Bandstrukturrechnungen auf Grundlage des Ebenen-Wellen-Expansionsverfahrens durchgeführt.
Hierzu wurde das Gitter als feste rechtwinklige Siliziumstrahlen, die in einer klassischen *woodpile* Struktur vor einem Hintergrund aus Luft angeordnet sind, modelliert. Ein Wert von *n* = *3*,*45* für den Brechungsindex von nc-Si:H wurde aufgrund der Übereinstimmung von experimentellen Befunden an dünnen Filmen auf Silikat mit Literaturangaben verwendet.

Das Ergebnis der Berechnungen für diese Struktur findet sich in **Fig. 3**. Diese Struktur besitzt eine Bandlücke von 23% (Breite der Bandlücke bezogen auf die Mittenfrequenz) bei einer Frequenz von 2,6 µm. Diese Bandstrukturrechnungen beweisen das Vorhandensein einer vollständigen photonischen Bandlücke mit einer ausgeprägten Struktur.

## Patentansprüche

1. Verfahren zur Herstellung eines Photonischen Kristalls, der aus einem Material mit hohem Brechungsindex besteht, umfassend die folgenden Verfahrensschritte:
a) Bereitstellen eines Photonischen Kristalls, der aus einem Polymer besteht und durch dessen Oberfläche leere Zwischengitterplätze gegeben sind, wobei der Photonische Kristall, der aus einem Polymer besteht, auf ein erstes Substrat aufgebracht wird,
b) Einbringen eines Füllstoffs in die Zwischengitterplätze, so dass sich darin ein Netzwerk aus dem Füllstoff bildet,
c) Entfernen des Polymers, wodurch in dem aus dem Füllstoff gebildeten Netzwerk Hohlräume entstehen,
d) Einbringen eines Materials mit hohem Brechungsindex in die Hohlräume, so dass sich darin eine Struktur aus dem Material mit hohem Brechungsindex bildet,
e) Entfernen des Füllstoffs, wodurch die Struktur aus dem Material mit hohem Brechungsindex zurückbleibt, die als Photonischer Kristall, der aus einem Material mit hohem Brechungsindex besteht, entnommen werden kann,
**dadurch gekennzeichnet, dass** der Photonische Kristall, der aus einem Polymer besteht, mittels direktem Laserschreiben hergestellt wird, und dass das Verfahren nach Verfahrensschritt b) den Verfahrensschritt
b1) Aufbringen eines zweiten Substrats auf die Oberfläche des Photonischen Kristalls, der aus einem Polymer besteht, nachdem sich in dessen Zwischengitterplätzen ein Netzwerk aus dem Füllstoff gebildet hat, oder
b2) alternativ, falls kein zweites Substrat aufgebracht wird, Entfernung der obersten Schicht aus dem Follstoff mittels reaktivem lonenätzen,
umfasst.

2. Verfahren nach Anspruch 1, wobei der Photonische Kristall, der aus einem Polymer besteht, auf einer Schicht aus demselben Polymer, die das erste Substrat bedeckt, aufgebracht wird.

3. Verfahren nach einem der Ansprüche 1 oder 2, wobei eine Vorläufersubstanz des Füllstoffs in den Photonischen Kristall, der aus einem Polymer besteht, bis zu einem Füllgrad, der so gewählt ist, dass der Füllstoff nach Entfernen des Polymers ein Hohlräume umfassendes Netzwerk bildet, eingefüllt wird.

4. Verfahren nach einem der Ansprüche 1 bis 3 mit Silikat (SiO₂) als Füllstoff.

5. Verfahren nach Anspruch 4 mit Siliziumtetrachlorid (SiCl₄) als Vorläufersubstanz des Füllstoffs.

6. Verfahren nach einem der Ansprüche 1 bis 5, wobei das zweite Substrat mittels einem Sol-Gel-Verfahren oder einem Klebstoff aufgebracht wird.

7. Verfahren nach einem der Ansprüche 1 bis 6, wobei das Entfernen des Polymers mittels Plasmaätzen oder thermischer Zersetzung erfolgt.

8. Verfahren nach einem der Ansprüche 1 bis 7, wobei das Material mit hohem Brechungsindex schichtweise in die Hohlräume eingebracht wird.

9. Verfahren nach einem der Ansprüche 1 bis 8 mit Silizium, Germanium oder einer Legierung aus beiden Halbleitern als Material mit hohem Brechungsindex.

10. Verfahren nach Anspruch 9 mit hydriertem nanokristallinen Silizium (nc-Si:H) als Material mit hohem Brechungsindex.

11. Verfahren nach einem der Ansprüche 1 bis 10, wobei nach dem Einbringen des Materials mit hohem Brechungsindex in die Hohlräume ein drittes Substrat, das widerstandsfähig gegen starke Säuren ist, mit einem optisch transparenten Kleber aufgebracht wird.

12. Verfahren nach einem der Ansprüche 1 bis 11, wobei das Entfernen des Füllstoffs mittels einer Säure erfolgt.

13. Verfahren nach Anspruch 12 wobei der Füllstoff zusammen mit dem ersten Substrat oder dem zweiten Substrat mit einer starken Säure entfernt wird.

## Claims

1. A process for producing a photonic crystal which consists of a material having a high refractive index, comprising the following process steps:
a) providing a photonic crystal which consists of a polymer and through the surface of which there are empty interstitial sites, whereby the photonic crystal which consists of a polymer, is applied to a first substrate.
b) introducing a filler into the interstitial sites, so that a network of the filler is formed therein,
c) removing the polymer, whereby cavities are formed in the network formed by the filler,
d) introducing a material with a high refractive index into the cavities, so that a structure of the material with a high refractive index is formed therein,
e) removing the filler, whereby the structure of the material with a high refractive index is left, which can be removed as a photonic crystal which consists of a material with a high refractive index,
**characterized in that** the photonic crystal which consists of a polymer, is produced by means of direct laser inscription and **in that** the procedure according to process b) consists of the process step
b1) applying a second substrate to the surface of the photonic crystal which consists of a polymer, after a network from the filler has been formed in its interstitial sites,
b2) alternatively, if no second substrate is applied, removal of the upmost layer from the filler by means of a reactive-ion etching.

2. The process as claimed in claim 1, wherein the photonic crystal which consists of a polymer is applied to a layer of the same polymer, which covers the first substrate.

3. The process as claimed in one of claims 1 or 2, wherein a precursor substance of the filler is introduced into the photonic crystal which consists of a polymer, up to a fill level, which is selected such that the filler, after removal of the polymer, forms a network enfolding cavities.

4. The process as claimed in one of claims 1 to 3 with silicate (SiO₂) as filler.

5. The process as claimed in claim 4 with silicon tetrachloride (SiCl₄) as the precursor substance of the filler.

6. The process as claimed in claim 1 to 5, wherein the second substrate is applied by means of a sol-gel process or an adhesive.

7. The process as claimed in one of claims 1 to 6, wherein the polymer is removed by means of plasma etching or thermal decomposition.

8. The process as claimed in one of claims 1 to 7, wherein the material with a high refractive index is introduced layer by layer into the cavities.

9. The process as claimed in one of claims 1 to 8 with silicon, germanium or an alloy of the two semiconductors as material with a high refractive index.

10. The process as claimed in claim 9 with hydrogenated nanocrystalline silicon (nc-Si:H) as material with a high refractive index.

11. The process as claimed in one of claims 1 to 10, wherein, after the introduction of the material with a high refractive index into the cavities, a third substrate which is resistant toward strong acids is applied with a visually transparent adhesive.

12. The process as claimed in one of claims 1 to 11, wherein the filler is removed by means of an acid.

13. The process as claimed in claim 12, wherein the filler is removed with a strong acid together with the first or the second substrate.

## Revendications

1. Procédé de fabrication d'un cristal photonique constitué d'un matériau d'indice de réfraction élevé, comprenant les étapes de procédé suivantes :
a) fourniture d'un cristal photonique constitué d'un polymère et à travers la surface duquel des interstices vides sont produits, dans lequel le cristal photonique constitué d'un polymère est appliqué sur un premier substrat,
b) introduction d'une matière de remplissage dans les interstices de manière à ce qu'un réseau s'y forme à partir de la matière de remplissage,
c) élimination du polymère, de manière à ce que des cavités se créent dans le réseau formé à partir de la matière de remplissage,
d) introduction d'un matériau d'indice de réfraction élevé dans les cavités de manière à ce qu'il s'y forme une structure constituée du matériau d'indice de réfraction élevé,
e) élimination de la matière de remplissage, de manière à ce que la structure constituée du matériau d'indice de réfraction élevé subsiste, celle-ci pouvant être obtenue en tant que cristal photonique constitué d'un matériau d'indice de réfraction élevé,
**caractérisé en ce que** le cristal photonique constitué d'un polymère est fabriqué par gravure directe au laser, et **en ce que** le procédé, après l'étape de procédé b), comprend l'étape de procédé suivante :
b1) dépôt d'un deuxième substrat sur la surface du cristal photonique constitué d'un polymère après qu'un réseau constitué de la matière de remplissage se soit formé dans ses interstices, ou
b2) en variante, dans le cas où un deuxième substrat n'est pas appliqué, élimination de la couche supérieure constituée de la matière de remplissage par attaque ionique réactive.

2. Procédé selon la revendication 1, dans lequel le cristal photonique constitué d'un polymère est appliqué sur une couche constituée du même polymère, qui recouvre le premier substrat.

3. Procédé selon la revendication 1 ou 2, dans lequel un précurseur de la matière de remplissage est introduit dans le cristal photonique constitué d'un polymère jusqu'à un degré de remplissage sélectionné de manière à ce que la matière de remplissage forme un réseau comprenant des cavités après élimination du polymère.

4. Procédé selon l'une quelconque des revendications 1 à 3, comprenant un silicate (SiO₂) en tant que matière de remplissage.

5. Procédé selon la revendication 4, comprenant du tétrachlorure de silicium (SiCl₄) en tant que précurseur de la matière de remplissage.

6. Procédé selon l'une quelconque des revendications 1 à 5, dans lequel le deuxième substrat est appliqué au moyen d'un procédé sol-gel ou d'un adhésif.

7. Procédé selon l'une quelconque des revendications 1 à 6, dans lequel l'élimination du polymère s'effectue par attaque au plasma ou décomposition thermique.

8. Procédé selon l'une quelconque des revendications 1 à 7, dans lequel le matériau d'indice de réfraction élevé est introduit sous forme de couches dans les cavités.

9. Procédé selon l'une quelconque des revendications 1 à 8, comprenant du silicium, du germanium ou un alliage constitué des deux semiconducteurs en tant que matériau d'indice de réfraction élevé.

10. Procédé selon la revendication 9, comprenant du silicium hydrogéné nanocristallin (nc-Si:H) en tant que matériau d'indice de réfraction élevé.

11. Procédé selon l'une quelconque des revendications 1 à 10, dans lequel, après l'introduction du matériau d'indice de réfraction élevé dans les cavités, un troisième substrat résistant aux acides forts est appliqué à l'aide d'un adhésif optiquement transparent.

12. Procédé selon l'une quelconque des revendications 1 à 11, dans lequel l'élimination de la matière de remplissage s'effectue au moyen d'un acide.

13. Procédé selon la revendication 12, dans lequel la matière de remplissage est éliminée en même temps que le premier substrat ou que le deuxième substrat à l'aide d'un acide fort.
